# EUROPEAN PATENT SPECIFICATION

(11) **EP 3 647 296 B1**
(45) Date of publication and mention of the grant of the patent: **03.04.2024**
(21) Application number: 18824430.5
(22) Date of filing: 22.06.2018
(51) Int. Cl.: C04B 35/111, C04B 38/00, H01C 17/065, H05K 1/03, C04B 111/00

(54) **ALUMINA SUBSTRATE AND RESISTOR USING SAME**
ALUMINIUMOXIDSUBSTRAT UND WIDERSTAND DAMIT
SUBSTRAT D'ALUMINE ET RÉSISTANCE L'UTILISANT

(30) Priority: 29.06.2017 JP 2017127607
(43) Date of publication of application: 06.05.2020
(73) Proprietor: Kyocera Corporation, Kyoto-shi Kyoto 612-8501 (JP)
(72) Inventor: MATSUSHITA,Kouji, Kyoto-shi Kyoto 612-8501 (JP); TOMITA,Yuuki, Kyoto-shi Kyoto 612-8501 (JP)
(74) Representative: Viering, Jentschura & Partner mbB Patent- und Rechtsanwälte
(86) International application number: PCT/JP2018/023861
(87) International publication number: WO 2019/004091

(56) References cited:
- EP-A1- 2 460 783
- JP-A- H07 192 901
- JP-A- H11 150 001
- JP-A- 2000 195 703
- JP-A- 2000 311 805
- JP-A- 2004 276 604
- JP-A- 2005 239 463
- JP-A- 2006 089 358
- JP-A- 2015 125 896
- JP-A- 2016 134 431

## Description

### Field

The present disclosure relates to an alumina substrate and a resistor that uses it.

### Background

A resistor is conventionally used for highly accurate control of electronic equipment. Such a resistor includes a substrate and a resistance element that is located on the substrate. Herein, an alumina substrate that has an excellent insulation property and is inexpensive is widely used for a substrate of a resistor.

Herein, a resistor is manufactured by a manufacturing method where a resistance element is formed, by sputtering or the like, on a single alumina substrate with a division groove that is formed so as to provide a piece with a desired size and subsequently division thereof is executed so as to take multiple ones, from the viewpoint of mass-producibility thereof (see Patent Literature 1).

### Citation List

### Patent Literature

Patent Literature 1: Japanese Patent Application Publication No. H07-192901

### Summary

The present invention provides an alumina substrate according to claim 1 and a resistor according to claim 5.

Further embodiments are disclosed in the dependent claims.

### Brief Description of Drawings

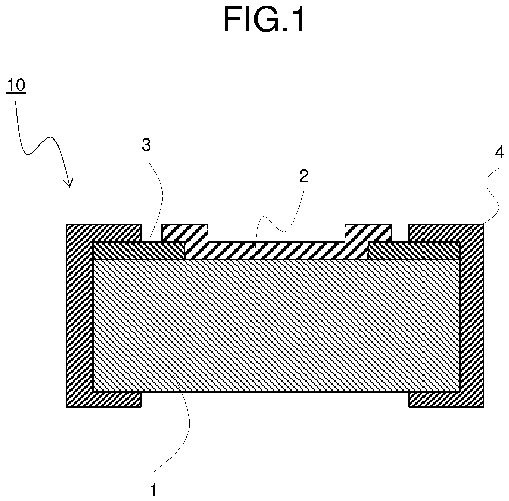

FIG. 1 is a cross-sectional view that illustrates an example of a configuration of a resistor according to the present disclosure.

### Description of Embodiments

If a large pore exists on a surface of an alumina substrate, an inside of such a pore is not sufficiently filled with a resistance element when the resistance element is formed by sputtering or the like, and a resistivity in a case where a resistor is provided may vary between a piece with a large pore that exists thereon and a piece with no large pore that exists thereon.

On the other hand, if no pore exists on a surface of an alumna substrate, a problem as described above is not caused, but it is difficult to divide the alumina substrate. In such a case, it takes time to divide an alumina substrate, so that production efficiency thereof is lowered.

Hence, an alumina substrate is desired that is provided with a decreased variation of a resistivity of a resistor and is readily divided.

An alumina substrate according to the present disclosure is provided with a decreased variation of a resistivity of a resistor and is readily divided. Furthermore, a resistor according to the present disclosure includes an alumina substrate as described above, and hence, has high reliability. Hereinafter, an alumina substrate according to the present disclosure and a resistor that uses it will be explained.

As illustrated in FIG. 1, a resistor 10 according to the present disclosure includes an alumina substrate 1 and a resistance element 2 that is located on the alumina substrate 1.

Herein, the alumina substrate 1 according to the present disclosure has a pore on a surface thereof and is composed of an alumina-based ceramic that contains 96% by mass or more of Al as a value of an Al₂O₃ equivalent among 100% by mass of all constituent components thereof. Thus, the alumina substrate 1 according to the present disclosure is composed of an alumina-based ceramic, and hence, has an excellent insulation property.

Herein, it is sufficient to calculate a content of Al as a value of an Al₂O₃ equivalent in the alumina substrate 1 according to the present disclosure by measuring a content of Al by using an ICP atomic emission spectrometer (ICP) or an X-ray fluorescence spectrometer (XRF) and subsequently converting it into an Al₂O₃ equivalent. Additionally, for a content of a contained component other than Al, it is sufficient to execute qualitative analysis by using an XRF and subsequently obtain its content for a detected element by an ICP or an XRF.

Then, in the alumina substrate 1 according to the present disclosure, a surface area occupancy of a pore is 1.5% or greater and 6.0% or less, an average value D of an equivalent circle diameter of a pore is 0.9 µm or greater and 2.0 µm or less, and a standard deviation Dσ of an equivalent circle diameter of a pore is 1.0 µm or less. Such a configuration is satisfied, so that the alumina substrate 1 according to the present disclosure is provided with a decreased variation of a resistivity of the resistor 10 and is readily divided.

On the contrary, if a surface area occupancy of a pore is less than 1.5%, a less number of pores are provided, so that it is difficult to execute division. Furthermore, if a surface area occupancy of a pore is greater than 6.0%, a greater number of pores are provided, so that, when the alumina substrate 1 is divided into pieces thereof and the resistor 10 is manufactured by using such pieces, a resistivity of the resistor 10 for each piece readily varies.

Furthermore, if an average value D of an equivalent circle diameter of a pore is less than 0.9 µm, a pore is small, so that it is difficult to execute division. Furthermore, if an average value D of an equivalent circle diameter of a pore is greater than 2.0 µm, a pore is large, so that, when the alumina substrate 1 is divided into pieces and the resistor 10 is manufactured by using such pieces, a resistivity of the resistor 10 for each piece readily varies.

Furthermore, if a standard deviation Dσ of an equivalent circle diameter of a pore is greater than 1.0 µm, a large pore exists, so that, when the alumina substrate 1 is divided into pieces and the resistor 10 is manufactured by using such pieces, a resistivity of the resistor 10 for each piece readily varies.

Furthermore, in the alumina substrate 1 according to the present disclosure, a ratio Dσ/D of a standard deviation Dσ of an equivalent circle diameter of a pore to an average value D of an equivalent circle diameter of a pore may be less than 0.6. If such a configuration is satisfied, a variation of a size of a pore is further decreased. Hence, the alumina substrate 1 according to the present disclosure is provided with a further deceased variation of a resistivity of the resistor 10.

Furthermore, in the alumina substrate 1 according to the present disclosure, an average value L of a distance between centroids of pores may be 5.5 µm or greater and 14 µm or less. When such a configuration is satisfied, pores are appropriately dispersed. Hence, the alumina substrate 1 according to the present disclosure is provided with a decreased variation of a resistivity of the resistor 10 and is readily divided.

Furthermore, in the alumina substrate 1 according to the present disclosure, a standard deviation Lσ of a distance between centroids of pores may be 4.0 µm or less. When such a configuration is satisfied, a less number of locations with dense pores are provided and pores exist more uniformly. Hence, the alumina substrate 1 according to the present disclosure is provided with a decreased variation of a resistivity of the resistor 10 and is readily divided.

Furthermore, in the alumina substrate 1 according to the present disclosure, a skewness of a distribution curve of an equivalent circle diameter of a pore may be greater than 0. Herein, a distribution curve of an equivalent circle diameter of a pore refers to a curve that indicates a distribution of an equivalent circle diameter of a pore where a horizontal axis in a two-dimensional graph is an equivalent circle diameter of a pore and a vertical axis therein is the number of pores, and indicates a distribution range of an equivalent circle diameter of a pore.

Furthermore, a skewness is an index that indicates asymmetry of a distribution and is capable of being obtained by using a function SKEW that is included in Excel (registered trademark, Microsoft Corporation).

Additionally, a skewness that is greater than 0 means that the number of pores that have an equivalent circle diameter that is less than an average value D of an equivalent circle diameter of a pore is greater than the number of pores that have an equivalent circle diameter that is greater than the average value D of an equivalent circle diameter of a pore, in a distribution curve of an equivalent circle diameter of a pore.

Hence, if such a configuration is satisfied, a pore that has an equivalent circle diameter that is greater than an average value D of an equivalent circle diameter of a pore is present although the number thereof is small, so that it is possible to execute division, and a pore that has an equivalent circle diameter that is less than an average value D of an equivalent circle diameter of a pore is a half or more of an entire thereof, so that a variation of a resistivity of the resistor 10 is further decreased.

Furthermore, in the alumina substrate 1 according to the present disclosure, an average value of a degree of circularity of a pore is 0.5 or greater. Herein, a degree of circularity is 1 for a perfect circle and indicates a value that is decreased as a shape of a circle is lost. Then, if such a configuration is satisfied, a crack is less likely to be generated from a pore with a skewed shape in a direction that is not a direction for division when the alumina substrate 1 is divided into pieces thereof, so that division is executed more readily.

Herein, in the alumina substrate 1 according to the present disclosure, it is sufficient to measure a surface area occupancy of a pore, an average value D of an equivalent circle diameter of a pore, a standard deviation Dσ of an equivalent circle diameter of a pore, an average value L of a distance between centroids of pores, a standard deviation Lσ of a distance between centroids of pores, a skewness of a distribution curve of an equivalent circle diameter of a pore, and an average value of a degree of circularity of a pore, by a following method.

First, a surface of the alumina substrate 1 according to the present disclosure is mirror-polished to, for example, a depth of approximately 10 µm and an image thereof is captured at 1000-fold magnification by using a scanning electron microscope (SEM). Then, it is possible to obtain a surface area occupancy of a pore, an average value D of an equivalent circle diameter of a pore, a standard deviation Dσ of an equivalent circle diameter of a pore, and an average value of a degree of circularity of a pore by applying a technique of particle analysis of image analysis software "A zo-kun" (registered trademark, produced by Asahi Kasei Engineering Corporation. Additionally, in a case where image analysis software "A zo-kun" is described below, image analysis software produced by Asahi Kasei Engineering Corporation is indicated thereby.) to, for example, a range where a surface area is approximately 10 µm² on an image-captured photograph to execute image analysis, and an average value L of a distance between centroids of pores and a standard deviation Lσ of a distance between centroids of pores, by applying a technique of analysis of variance thereto to execute image analysis. Furthermore, it is possible to calculate a skewness of a distribution curve of an equivalent circle diameter of a pore from obtained data of an equivalent circle diameter of a pore. Herein, for an analysis condition of image analysis software "A zo-kun", it is sufficient that a lightness of a crystal particle is "dark", a method for binarization is "manual", a small graphic elimination surface area is 0.4 µm, and a threshold value that is an index that indicates light and dark of an image is 80 or greater and 120 or less.

Furthermore, the resistance element 2 may be composed of any material as long as an intended resistivity is provided. For example, it is sufficient that the resistance element 2 is composed of a nickel-chromium-based alloy or ruthenium oxide.

Furthermore, the resistor 10 according to the present disclosure may include an internal electrode 3 that is connected to the resistance element 2 and an end face electrode 4 that is connected to the internal electrode 3, as illustrated in FIG. 1, other than the alumina substrate 1 and the resistance element 2. Herein, the internal electrode 3 and the end face electrode 4 may be composed of any materials as long as they have conductive properties. For example, it is sufficient that the internal electrode 3 is composed of a silver-palladium-based alloy, a silver-platinum-based alloy, or gold. Furthermore, it is sufficient that the end face electrode 4 is composed of a nickel-chromium-based alloy, a nickel-copper-tin-based alloy, silver, or chromium.

Next, an example of a manufacturing method for an alumina substrate according to the present disclosure will be explained.

First, an alumina (Al₂O₃) powder that is a main raw material and a calcium carbonate (CaCOs) powder, a magnesium hydroxide (Mg(OH)₂) powder, and a silicon oxide (SiO₂) powder that are sintering aids are prepared.

Herein, for an alumina powder, two types of alumina powders are prepared where equivalent circle diameters at an accumulation of 50% on a cumulative distribution curve of an equivalent circle diameter of an alumina powder are 0.6 µm and 2.1 µm. Then, such two types of alumina powders are mixed so as to obtain a primary raw material powder. Herein, each of such two types of aluminum oxide powders is appropriately weighed and mixed, so that it is possible to adjust an average value D of an equivalent circle diameter of a pore to any value. Specifically, as a compounding ratio of an alumina powder with an equivalent circle diameter that is 2.1 µm is increased, a coarse pore is increased, so that an average value D of an equivalent circle diameter of a pore is increased. Furthermore, as a compounding ratio of an alumina powder with an equivalent circle diameter that is 0.6 µm is increased, a minute pore is increased, so that an average value D of an equivalent circle diameter of a pore is decreased.

Then, a primary raw material powder and respective powders that are sintering aids (a calcium carbonate powder, a magnesium hydroxide powder, and a silicon oxide powder) are weighed so as to provide 96% by mass or more of aluminum as a value of an Al₂O₃ equivalent among 100% by mass of all components that constitute an alumina substrate. Herein, it is preferable to weigh a primary raw material powder and respective powders that are sintering aids so that a total of silicon, calcium, and magnesium as values of SiO₂, CaO, and MgO equivalents, respectively, among 100% by mass of all components that constitute an alumina substrate, is 0.5% by mass or more and 4.0% by mass or less. Furthermore, it is preferable that a ratio of SiO₂, CaO, and MgO as described above is SiO₂: CaO: MgO = 47: 30: 23.

Then, a primary raw material powder, respective powders that are sintering aids, 3 parts by mass or more and 10 parts by mass or less of a binder such as a water-soluble acryl resin, and 20 parts by mass or more and 40 parts by mass or less of a solvent, per 100 parts by mass of a total of the primary raw material powder and the respective powders that are sintering aids are put, mixed and agitated in an agitator so as to obtain a slurry. Herein, it is possible to adjust a standard deviation Dσ of an equivalent circle diameter of a pore to any value by adjusting an amount of a solvent to be added. Specifically, as an amount of a solvent to be added is decreased, localization of a primary raw material powder in the solvent is caused, so that a standard deviation Dσ of an equivalent circle diameter of a pore is increased. On the other hand, as an amount of a solvent to be added is increased, localization of a primary raw material powder in the solvent is not readily caused, so that a standard deviation Dσ of an equivalent circle diameter of a pore is decreased.

Additionally, a dispersant that is composed of 0.05 parts by mass or more and 0.50 parts by mass or less of an ammonium polycaroboxylate salt per 100 parts by mass of a total of a primary raw material powder and respective powders that are sintering aids is put therein at a time of mixing and agitating, so that it is possible to provide an average value L of a distance between centroids of pores that is 5.5 µm or greater and 14 µm or less.

Furthermore, a period of time to execute mixing and agitating is adjusted appropriately, so that it is possible to provide a skewness of a distribution curve of an equivalent circle diameter of a pore that is any value. Specifically, if mixing and agitating are executed for 12 hours or more, a skewness of a distribution curve of an equivalent circle diameter of a pore is greater than 0.

Furthermore, if a slurry that is obtained by mixing and agitating is passed through meshes with various different opening sizes or the like so as to execute adjustment in such a manner that a value of an equivalent circle diameter at an accumulation of 10% and a value of an equivalent circle diameter at an accumulation of 90% on a cumulative distribution curve of an equivalent circle diameter of alumina are similar in alumina in a slurry, it is possible to provide an average value of a degree of circularity of a pore that is close to 1 and it is possible to provide an average value of a degree of circularity of a pore that is 0.5 or greater.

Then, a sheet is formed by using such a slurry according to a doctor blade method. Additionally, a thickness of a sheet may be adjusted in such a manner that a thickness after firing is 0.1 mm or greater and 1.0 mm or less.

Then, a sheet as described above is processed by mold pressing or laser processing, so that a molded body with a predetermined product shape is obtained.

Then, an obtained molded body is put in a firing furnace under air (oxidation) atmosphere (for example, a roller-type tunnel furnace, a batch-type atmosphere furnace, and a pusher-type tunnel furnace) and held and fired at a temperature with a maximum temperature of 1500 °C or greater and 1600 °C or less for 3 hours or more and 10 hours or less so as to obtain a sintered body. Thus, firing with a maximum temperature and a holding time as described above is executed, so that it is possible to provide a surface area occupancy of a pore that is 1.5% or greater and 6.0% or less.

Then, a surface of such a sintered body is polished so as to obtain an alumina substrate according to the present disclosure. Additionally, an arithmetic mean roughness Ra of a surface that is 0.3 µm or less may be provided by such polishing.

Furthermore, a division groove is formed on an alumina substrate according to the present disclosure so as to provide pieces with a desired size. Then, a metal paste that is mainly composed of a silver-palladium-based alloy, a silver-platinum-based alloy, gold, or the like is printed and fired so as to form an internal electrode. Then, a resistance element is formed by sputtering of a nickel-chromium-based alloy, ruthenium oxide, or the like. Then, an alumina substrate is divided into strip shapes along a division groove and an end face electrode is formed by sputtering of a nickel-chromium-based alloy, a nickel-copper-tin-based alloy, silver, chromium, or the like. Then, division into pieces is executed so as to obtain a resistor according to the present disclosure. Additionally, as needed, a resistance element may be covered with a protective layer that is composed of a resin or plating may be applied to exposed portions of an internal electrode and an end face electrode.

Hereinafter, although practical examples according to the present disclosure will be explained specifically, the present disclosure is not limited to such practical examples.

### Practical Example 1 (not according to the invention)

Samples with an average value D of an equivalent circle diameter of a pore and a standard deviation Dσ of an equivalent circle diameter of a pore that were different were fabricated and a variation of a resistivity of a resistor and a division property were evaluated.

First, an alumina powder that was a main raw material and a calcium carbonate powder, a magnesium hydroxide powder, and a silicon oxide powder that were sintering aids were prepared. Herein, for the alumina powder, two types of alumina powders were prepared where equivalent circle diameters at an accumulation of 50% on a cumulative distribution curve of an equivalent circle diameter of an alumina powder were 0.6 µm and 2.1 µm. Then, such two types of alumina powders were mixed so as to obtain a primary raw material powder. Then, the primary raw material powder and the respective powders (the calcium carbonate powder, the magnesium hydroxide powder, and the silicon oxide powder) that were sintering aids were weighed in such a manner that 1% by mass of silicon, calcium, and magnesium as a total of values of SiO₂, CaO, and MgO equivalents, respectively, and 99% by mass of a balance or aluminum as a value of an Al₂O₃ equivalent, among 100% by mass of all components that constituted an alumina substrate. Additionally, a ratio of SiO₂, CaO, and MgO as described above was provided as SiO₂: CaO: MgO = 47: 30: 23.

Then, the primary raw material powder, the respective powders that were sintering aids, 7 parts by mass of a binder such as a water-soluble acryl resin, per 100 parts by mass of a total of the primary raw material powder and the respective powders that were sintering aids, and water were put, mixed, and agitated in an agitator so as to obtain a slurry.

Herein, a compounding ratio of the two types of aluminum oxide powders as described above and an amount of water to be added were adjusted so as to provide an average value D of an equivalent circle diameter of a pore and a standard deviation Dσ of an equivalent circle diameter of a pore as illustrated in Table 1.

Then, a sheet was formed by using such a slurry according to a doctor blade method. Additionally, a thickness of the sheet was adjusted in such a manner that a thickness after firing was 0.2 mm.

Then, the sheet as described above was processed by mold pressing or laser processing so as to obtain a molded body with a size after firing (vertical × horizontal) that was 110 mm × 110 mm.

Then, the obtained molded body was put in a firing furnace (a roller-type tunnel furnace) under air atmosphere and held and fired at a temperature with a maximum temperature of 1550 °C or less for 5 hours so as to obtain a sintered body.

Then, a surface of such a sintered body was polished in such a manner that an arithmetic mean roughness Ra of the surface was 0.3 µm, and each sample was obtained.

Then, mirror polishing was executed from a surface of each sample to a depth of 10 µm and an image was captured at 1000-fold magnification by using an SEM. Then, image analysis was executed by applying a technique of particle analysis of image analysis software "A zo-kun" to a range with a surface area that was approximately 10 µm² in a captured photograph so as to obtain a surface area occupancy of a pore, an average value D of an equivalent circle diameter of a pore, and a standard deviation Dσ of an equivalent circle diameter of a pore, for each sample. Additionally, all of surface area occupancies of a pore of the respective samples were 4%.

Herein, for analysis conditions of the image analysis software "A zo-kun", a lightness of a crystal particle was "dark", a method for binarization was "manual", a small graphic elimination surface area was 0.4 µm, and a threshold value that was an index that indicated light and dark of an image was 100.

Then, a variation of a resistivity of a resistor was evaluated for each example. First, division grooves were formed on each sample so as to provide pieces with a desired size. Then, an internal electrode that was composed of silver-palladium was formed on each sample by printing thereof, subsequently a nickel-chromium-based alloy was sputtered in such a manner that its thickness was 100 nm, and subsequently a pattern of a resistance element was formed by photolithography and etching. Then, division into 4 strip shapes was executed along the division grooves in such a manner that 5 resistance elements were mounted on each thereof. Subsequently, an end face electrode that was composed of a nickel-copper-tin-based alloy was formed by sputtering. Then, this was further divided into 5 pieces, so that 20 samples with vertical × horizontal that was 1.0 mm × 0.5 mm were prepared for each sample. Then, among 20 samples, the number of ones with a resistivity of a resistance element that varied by 0.1% or greater at a time when a voltage of 2 kV was applied to the resistance element was counted. Then, each sample was ranked in ascending order of the number of samples with a resistivity of a resistance element that varied by 0.1% or greater. Herein, a sample with the number of ones as described above that was minimum was ranked at a top thereof and a sample with the number of ones as described above that was maximum was ranked at a bottom thereof. Herein, it was indicated that a variation of a resistivity of a resistor was decreased as the number of ones as described above was decreased.

Furthermore, a division property was evaluated for each sample. First, cutting of each sample was executed by using a rotating disk where diamond abrasive grains with a grain size of 1 µm were laid on a surface thereof, at a rotational speed of 2000 rpm. Herein, a load current of a rotational shaft of the rotating disk was measured. Then, each sample was ranked in ascending order of such a load current of the sample. Herein, a sample with a load current that was minimum was ranked at a top thereof and a sample with a load current that was maximum was ranked at a bottom thereof. Herein, it was indicated that division was readily executed as a load current was decreased. Results are illustrated in Table 1.

**Table 1**

| Sample No. | Average value D of equivalent circle diameter of pore (µm) | Standard deviation Dσ of equivalent circle diameter of pore (µm) | Dσ/D | Ranking of division property | Ranking of variation of resistivity |
|---|---|---|---|---|---|
| 1 | 0.7 | 0.2 | 0.29 | 10 | 1 |
| 2 | 0.8 | 0.3 | 0.38 | 9 | 2 |
| 3 | 0.9 | 0.3 | 0.33 | 8 | 3 |
| 4 | 1.2 | 0.4 | 0.33 | 7 | 4 |
| 5 | 1.5 | 0.5 | 0.33 | 6 | 5 |
| 6 | 1.5 | 0.6 | 0.40 | 5 | 6 |
| 7 | 1.6 | 1.0 | 0.63 | 4 | 8 |
| 8 | 2.0 | 1.0 | 0.50 | 3 | 7 |
| 9 | 2.0 | 1.1 | 0.55 | 2 | 9 |
| 10 | 2.2 | 1.1 | 0.50 | 1 | 10 |

As illustrated in Table 1, for sample Nos. 3 to 8, relative to sample Nos. 1, 2, 9, and 10, ranking of a variation of a resistivity was 8th or higher and ranking of a division property was 8th or higher. From such results, it was found that an alumina substrate with an average value D of an equivalent circle diameter of a pore that was 0.9 µm or greater and 2.0 µm or less and a standard deviation Dσ of an equivalent circle diameter of a pore that was 1.0 µm or less was provided with a decreased variation of a resistivity of a resistor and was readily divided.

Furthermore, ranking of a variation of a resistivity for sample Nos. 3 to 6 and 8 was higher than sample No. 7, so that it was found that an alumina substrate with a ratio Dσ/D of a standard deviation Dσ of an equivalent circle diameter of a pore to an average value D of an equivalent circle diameter of a pore that was less than 0.6 was provided with a further decreased variation of a resistivity of a resistor.

### Practical Example 2 (not according to the invention)

Next, samples with an average value L of a distance between centroids of pores that was different were fabricated and a variation of a resistivity of a resistor and a division property were evaluated.

Additionally, a fabrication method for each sample was similar to the fabrication method for sample No. 5 in Practical Example 1 except that a dispersant that was composed of an ammonium polycarboxylate salt with an amount in Table 2 was put in 100 parts by mass of a total of the primary raw material powder and the respective powders that were sintering aids at a time of mixing and agitating in such a manner that an average value L of a distance between centroids of pores was a value in Table 2. Additionally, sample No. 11 was identical to sample No. 5 in Practical Example 1.

Then, an average value L of a distance between centroids of pores for each sample was measured by applying a technique of analysis of variance thereto to execute image analysis according to a method that was identical to the method for obtaining a surface area occupancy of a pore, an average value D of an equivalent circle diameter of a pore, and a standard deviation Dσ of an equivalent circle diameter of a pore in Practical Example 1.

Then, a variation of a resistivity of a resistor and a division property for each sample were evaluated according to a method that was identical to that of Practical Example 1.

Results are illustrated in Table 2. Additionally, ranking in Table 2 is provided by comparing only samples that are illustrated in Table 2.

**Table 2**

| Sample No. | Dispersant (parts by mass) | Average value L of distance between centroids of pores (µm) | Ranking of division property | Ranking of variation of resistivity |
|---|---|---|---|---|
| 11 | 0.01 | 5.0 | 1 | 7 |
| 12 | 0.05 | 5.5 | 2 | 6 |
| 13 | 0.15 | 6.7 | 3 | 5 |
| 14 | 0.30 | 7.3 | 4 | 4 |
| 15 | 0.45 | 10.3 | 5 | 3 |
| 16 | 0.50 | 14.0 | 6 | 2 |
| 17 | 0.55 | 15.2 | 7 | 1 |

As illustrated in Table 2, for sample Nos. 12 to 16, relative to sample Nos. 11 and 17, ranking of a variation of a resistivity was 6th or higher and ranking of a division property was 6th or higher. Accordingly, it was found that an alumina substrate with an average value L of a distance between centroids of pores that was 5.5 µm or greater and 14 µm or less was provided with a further decreased variation of a resistivity of a resistor and was divided more readily.

### Practical Example 3 (not according to the invention)

Next, samples with a skewness of a distribution curve of an equivalent circle diameter of a pore that was different were fabricated and a variation of a resistivity of a resistor was evaluated.

Additionally, a fabrication method for each sample was similar to the fabrication method for sample No. 14 in Practical Example 2 except that a period of time to execute mixing and agitating was appropriately adjusted in such a manner that a skewness of a distribution curve of an equivalent circle diameter of a pore was a value in Table 3. Additionally, sample No. 21 was identical to sample No. 14 in Practical Example 2.

Then, a skewness of a distribution curve of an equivalent circle diameter of a pore for each sample was measured by executing image analysis according to a method that was identical to the method for obtaining a surface area occupancy of a pore, an average value D of an equivalent circle diameter of a pore, and a standard deviation Dσ of an equivalent circle diameter of a pore in Practical Example 1, and obtained from obtained data.

Then, a variation of a resistivity of a resistor for each sample was evaluated according to a method that was identical to that of Practical Example 1.

Results are illustrated in Table 3. Additionally, ranking in Table 3 is provided by comparing only samples that are illustrated in Table 3.

**Table 3**

| Sample No. | Skewness | Ranking of variation of resistivity |
|---|---|---|
| 18 | 3.2 | 1 |
| 19 | 2.3 | 2 |
| 20 | 0.8 | 3 |
| 21 | -0.5 | 4 |

As illustrated in Table 3, for sample Nos. 18 to 20, relative to sample No. 21, ranking of a variation of a resistivity was higher. Accordingly, it was found that an alumina substrate with a skewness of a distribution curve of an equivalent circle diameter of a pore that was greater than 0 was provided with a further decreased variation of a resistivity of a resistor.

### Practical Example 4

Next, samples with an average value of a degree of circularity of a pore that was different were fabricated and a division property was evaluated.

Additionally, a fabrication method for each sample was similar to the fabrication method for sample No. 18 in Practical Example 4 except that a slurry that was obtained by mixing and agitating was passed through meshes with various different opening sizes or the like so as to appropriately adjust a value of an equivalent circle diameter at an accumulation of 10% and a value of an equivalent circle diameter at an accumulation of 90% on a cumulative distribution curve of an equivalent circle diameter of alumina, in the alumina in a slurry, in such a manner that an average value of a degree of circularity of a pore was a value in Table 4. Additionally, sample No. 24 was identical to sample No. 18 in Practical Example 4.

Then, an average value of a degree of circularity of a pore for each sample was measured and obtained by executing image analysis according to a method that was identical to the method for obtaining a surface area occupancy of a pore, an average value D of an equivalent circle diameter of a pore, and a standard deviation Dσ of an equivalent circle diameter of a pore in Practical Example 1.

Then, a division property for each sample was evaluated according to a method that was identical to that of Practical Example 1.

Results are illustrated in Table 4. Additionally, ranking in Table 4 is provided by comparing only samples that are illustrated in Table 4.

**Table 4**

| Sample No. | Average value of degree of circularity of pore | Ranking of division property |
|---|---|---|
| 22 | 0.7 | 1 |
| 23 | 0.5 | 2 |
| 24 | 0.4 | 3 |

As illustrated in Table 4, for sample Nos. 22 and 23, relative to sample No. 24, ranking of a division property was higher. Accordingly, it was found that an alumina substrate with an average value of a degree of circularity of a pore that was 0.5 or greater was divided more readily.

### Reference Signs List

1: alumina substrate
2: resistance element
3: internal electrode
4: end face electrode
10: resistor

## Claims

1. An alumina substrate (1) that has a pore on a surface thereof and is composed of an alumina-based ceramic that contains 96% by mass or more of Al as a value of an Al₂O₃ equivalent among 100% by mass of all constituent components thereof, wherein a surface area occupancy of the pore, obtained by capturing an image of a mirror-polished surface of the alumina substrate (1) at 1000-fold magnification using a scanning electron microscope, is 1.5% or greater and 6.0% or less, an average value D of an equivalent circle diameter of the pore is 0.9 µm or greater and 2.0 µm or less, and a standard deviation Dσ of an equivalent circle diameter of the pore is 1.0 µm or less, wherein an average value of a degree of circularity of the pore is 0.5 or greater.

2. The alumina substrate (1) according to claim 1, wherein a ratio Dσ/D of a standard deviation Dσ of an equivalent circle diameter of the pore to an average value D of an equivalent circle diameter of the pore is less than 0.6.

3. The alumina substrate (1) according to claim 1 or claim 2, wherein an average value L of a distance between centroids of the pores is 5.5 µm or greater and 14 µm or less.

4. The alumina substrate (1) according to any of claim 1 to claim 3, wherein a skewness of a distribution curve of an equivalent circle diameter of the pore is greater than 0, meaning that the number of pores that have the equivalent circle diameter that is less than the average value D of the equivalent circle diameter of the pore is greater than the number of pores that have the equivalent circle diameter that is greater than the average value D of the equivalent circle diameter of the pore, obtained by using a function SKEW that is included in Excel.

5. A resistor (10), comprising:
the alumina substrate (1) according to any of claim 1 to claim 4; and
a resistance element (2) that is located on the alumina substrate (1) .

## Patentansprüche

1. Aluminiumoxid-Substrat (1), das eine Pore an einer Fläche davon hat und aus einer aluminiumoxidbasierten Keramik zusammengesetzt ist, die 96 Masse-% oder mehr Al als einen Wert eines Al₂O₃-Äquivalents unter 100 Masse-% aller konstituierenden Komponenten davon enthält, wobei eine Flächenbelegung der Pore, erhalten durch Aufnehmen eines Bildes einer spiegelpolierten Fläche des Aluminiumoxid-Substrats (1) bei 1000-facher Vergrößerung mittels eines Rasterelektronenmikroskops, 1,5 % oder mehr und 6,0 % oder weniger beträgt, ein Durchschnittswert D eines äquivalenten Kreisdurchmessers der Pore 0,9 µm oder mehr und 2,0 µm oder weniger beträgt, und eine Standardabweichung Dσ eines äquivalenten Kreisdurchmessers der Pore 1,0 µm oder weniger beträgt, wobei ein Durchschnittswert eines Grades der Kreisförmigkeit der Pore 0,5 oder mehr beträgt.

2. Aluminiumoxid-Substrat (1) gemäß Anspruch 1, wobei ein Verhältnis Dσ/D einer Standardabweichung Dσ eines äquivalenten Kreisdurchmessers der Pore zu einem Durchschnittswert D eines äquivalenten Kreisdurchmessers der Pore weniger als 0,6 beträgt.

3. Aluminiumoxid-Substrat (1) gemäß Anspruch 1 oder Anspruch 2, wobei ein Durchschnittswert L eines Abstands zwischen Mittelpunkten/Schwerpunkten der Poren 5,5 µm oder mehr und 14 µm oder weniger beträgt.

4. Aluminiumoxid-Substrat (1) gemäß irgendeinem von Anspruch 1 bis Anspruch 3, wobei eine Schiefe einer Verteilungskurve eines äquivalenten Kreisdurchmessers der Pore größer als 0 ist, was bedeutet, dass die Anzahl von Poren, die den äquivalenten Kreisdurchmesser haben, der kleiner als der Durchschnittswert D des äquivalenten Kreisdurchmessers der Pore ist, größer als die Anzahl von Poren ist, die den äquivalenten Kreisdurchmesser haben, der größer als der Durchschnittswert D des äquivalenten Kreisdurchmessers der Pore ist, erhalten durch Verwendung einer SKEW-Funktion, die in Excel enthalten ist.

5. Widerstand (10), aufweisend:
das Aluminiumoxid-Substrat (1) gemäß irgendeinem von Anspruch 1 bis Anspruch 4 und
ein Widerstandselement (2), das auf dem Aluminiumoxid-Substrat (1) angeordnet ist.

## Revendications

1. Substrat d'alumine (1) présentant un pore sur une surface de celui-ci et composé d'une céramique à base d'alumine contenant 96 % en masse ou plus d'Al en tant que valeur d'un équivalent d'Al₂O₃ parmi 100 % en masse de tous les composants constituants de celui-ci, dans lequel une surface occupée du pore, obtenue en capturant une image d'une surface polie au miroir du substrat d'alumine (1) à un grossissement de 1000 fois en utilisant un microscope électronique à balayage, est de 1,5 % ou plus et de 6,0 % ou moins, une valeur moyenne D d'un diamètre de cercle équivalent du pore est de 0,9 µm ou plus et de 2,0 µm ou moins, et un écart type Dσ d'un diamètre de cercle équivalent du pore est de 1,0 µm ou moins, dans lequel une valeur moyenne d'un degré de circularité du pore est de 0,5 ou plus.

2. Substrat d'alumine (1) selon la revendication 1, dans lequel un rapport Dσ/D d'un écart type Dσ d'un diamètre de cercle équivalent du pore à une valeur moyenne D d'un diamètre de cercle équivalent du pore est inférieur à 0,6.

3. Substrat d'alumine (1) selon la revendication 1 ou la revendication 2, dans lequel une valeur moyenne L d'une distance entre des centroïdes des pores est de 5,5 µm ou plus et de 14 µm ou moins.

4. Substrat d'alumine (1) selon l'une quelconque de la revendication 1 à la revendication 3, dans lequel une asymétrie d'une courbe de distribution d'un diamètre de cercle équivalent du pore est supérieure à 0, ce qui signifie que le nombre de pores dont le diamètre de cercle équivalent est inférieur à la valeur moyenne D du diamètre de cercle équivalent du pore est supérieur au nombre de pores dont le diamètre de cercle équivalent est supérieur à la valeur moyenne D du diamètre de cercle équivalent du pore, obtenu en utilisant une fonction SKEW incluse dans Excel.

5. Résistance (10), comprenant :
le substrat d'alumine (1) selon l'une quelconque de la revendication 1 à la revendication 4 ; et
un élément de résistance (2) situé sur le substrat d'alumine (1).
